# EUROPEAN PATENT SPECIFICATION

(11) **EP 0 248 754 B1**
(45) Date of publication and mention of the grant of the patent: **03.02.1993**
(21) Application number: 87500025.9
(22) Date of filing: 12.05.1987
(51) Int. Cl.: H02M 7/48

(54) **Procedure and device for the conversion of electrical energy from direct into alternating**
Vorrichtung und Verfahren fuer die Umwandlung elektrischer Energie von Gleichstrom zu Wechselstrom
Méthode et appareil pour la conversion d'énergie électrique direct-alternatif

(30) Priority: 17.05.1986 ES 555077
(43) Date of publication of application: 09.12.1987
(73) Proprietor: Ortigosa Garcia, Juan, 28260 Galapagar (Madrid) (ES)
(72) Inventor: Ortigosa Garcia, Juan, 28260 Galapagar (Madrid) (ES)
(74) Representative: EGLI-EUROPEAN PATENT ATTORNEYS

(56) References cited:
- WO-A-81/03723
- DE-C- 762 081
- FR-A- 1 554 923
- US-A- 1 703 242

## Description

The present invention is related to a method for converting electrical energy from DC form to AC form in conformity with the preamble of claim 1.

The present invention is also related to a device for converting electrical energy from DC form to AC form in conformity with the preamble of claim 9.

More generally, as will be described in detail in the following, the present invention relates to a method for the conversion of direct current into alternating current by means of sequential switching, by which it is possible, using DC sources of suitable characteristics, to obtain alternating currents of any desired voltage and frequency and to recover any energy produced (as a consequence of Lenz's law) by self-induction in inductive loads during polarity reversals of the alternating currents.

A method of the kind mentioned in the preamble of claim 1 and a device of the type mentioned in the preamble of claim 9 are known from WO-A-81/03723.

As is known, the present production and distribution of electrical energy, as used at the international level, is oriented towards the use of alternating current, which implies basically that the vast majority of electrically driven apparatus available on the market is designed to use alternating current as supply power.

However, in practice, it is relatively common that e.g. for geographical reasons electrical power is not available in AC form, yet it is necessary to operate equipment which is designed for use with other than direct current. In such cases, where there is normally a storage battery or some similar unit, it is essential to make use of a converter which transforms the direct current into alternating current so as to permit the operation of the apparatus concerned from the previously mentioned DC power supply.

There are currently a large variety of converters on the market, using many different schemes for obtaining improved performance according to the specific application or use, specifically as a function of the nature of the power supply, the power to be transformed, the frequency required, etc.

The basic problem with such converters is that they consume an excessive amount of internal energy, which makes their use difficult, especially when the power supplies are of low power as frequently occurs where classical battery energy or photo-voltaic energy is used.

The object of the present invention is to resolve this problem by minimising internal energy consumption and permitting recovery of any energy produced by self-induction in inductive loads.

From the above-mentioned WO-A-81/03723 there is known a solution of this problem which is based on sequential switching, by means of successive sweeps of link points forming respective intermediate and end terminals between a plurality of DC supply sources. However, in this known device the intermediate terminals and at least one end terminal are switched to ground in the course of said successive sweeps, and there is provided a generally symmetric output circuit which generates an AC output energy whose voltage is symmetric across ground potential, i.e. the average potential at the AC output of this known device is equal to ground potential. Thus, this known device cannot provide an AC output energy having a floating average potential. To obtain an AC output energy having a floating average potential, it is compulsory to insert a transformer between the AC output and the load, which transformer hinders the recovery of any energy produced by self-induction in inductive loads.

The drawbacks of this known solution are overcome, in particular the recovery of any energy produced by self-induction in inductive loads is permitted, by use of the method and device of the present invention.

Specifically, the method of the present invention is characterized by the combination of method steps recited in claim 1, and the device of the present invention is characterized by the combination of features recited in claim 9. Preferred embodiments of the method of the present invention are recited in appended method claims 2 to 8, and preferred embodiments of the device of the present invention are recited in appended device claims 10 to 12.

The method and device of the present invention provide for the generation of AC energy with an AC wave form having a floating average potential, i.e. a potential unrelated to ground potential, and also provide for the recovery of any energy produced by self-induction in inductive loads.

### DESCRIPTION OF THE DRAWINGS.

In order to complete the description being made, and so as to assist in better understanding of the features of the invention, these specifications are accompanied, as an integral part hereof, by a set of drawings in which, by way of illustration, and without limitation, the following is shown:
Figure 1.- This shows a sample practical design of the procedure for the conversion of energy as advanced in the invention, corresponding to a theoretical and mechanical solution of extremely primitive type and which, in practise, would present all kinds of problems, in particular, from the switching point of view, but which is the most suitable for understanding the philosophy behind this procedure.
Figure 2.- A representation in schematic form of an electronic circuit for the practical design of the procedure, which, totally remote from the theoretical representation of the previous figure, is adjusted to practical reality.
Figure 3.- This figure, finally, shows details of the circuit for the control of each of the static switches involved in the general circuit of figure 2.

### DESCRIPTION OF THE PRESENTLY PREFERRED EMBODIMENT.

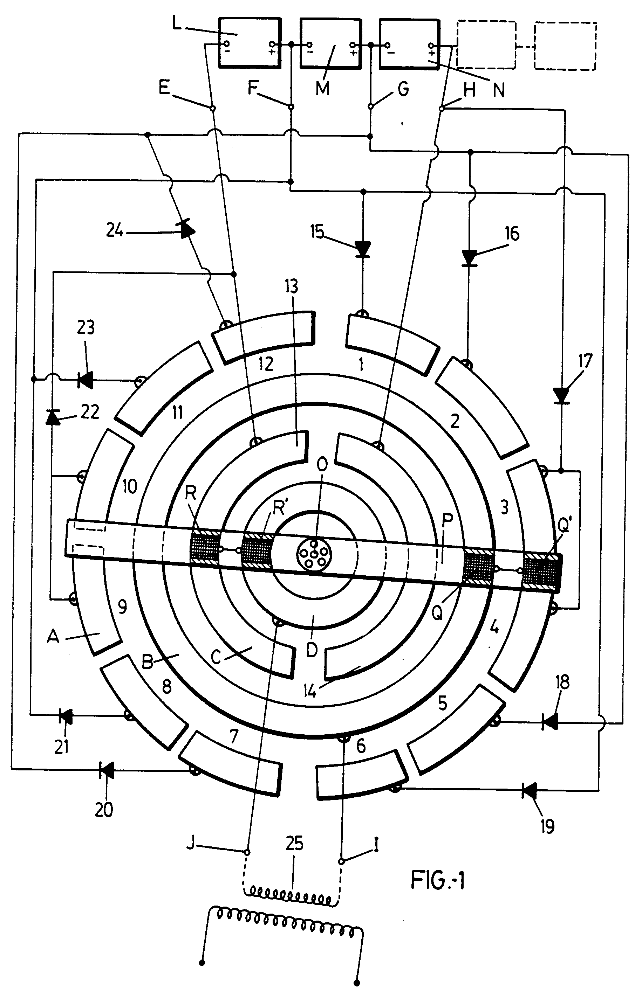

In the theoretical circuit of figure 1, it can be seen low the procedure being advanced is given form in the arrangement on a support (not shown) of four concentric tracks of electrolytic copper or any other conducting material electrically insulated amongst themselves and with a cross-section in accordance with the current intensities it is planned to pass through them. The said tracks are marked A, B, C and D in the drawing.

Track A is divided into segments or sectors 1, 2, 3, 4, 5, 6, 7, 8, 9, 10, 11, and 12 which are all of identical dimensions and of a variable number which is, however, a multiple of the number of DC supplies used. In this case, provision has been made for the use of three sources of direct current, referenced L, M, and N, so that the segments or sectors are twelve in number.

Track B is continuous, in other words, it is made up of a single piece, without divisions.

Track D, like B, is also of a single piece, undivided.

The said tracks A, B, and D are concentric; a cursor, P, collaborates with them, with its center of rotation coinciding with the point fixed by the concentricity of the said tracks; the said cursor, P, is rotary, being driven by a motor which is not shown in the figure.

Cursor P is designed to constitute the drive support element for four brushes Q-Qʹ connected together and intended to establish the point of electrical connection between tracks A and B, while brushes R-Rʹ are also interconnected and in turn establish the connection bridge between tracks C and D.

To return to the compartmentalization of tracks A and C, it should be emphasized that the size, and specifically the width of the brushes Qʹ must be more than the separation or distance between the different segments of track A, with the exception of the separation spaces between segments 1 and 12 on the one hand, and 6 and 7 on the other, which define two halves on this segmented track A, one for segments 1-6 and the other for segments 7-12. In this way, brush Qʹ, on passing from one segment to another, makes contact with the second before losing that with the first, except in the case where it passes from segments 6 to 7 and from 12 to 1, as pointed out above.

For its part, brush R which acts on track C is not as wide as the space between the two only sectors, 13 and 14, of this track.

According to the structure described, the different segments of the track are sequentially connected with track B through brushes Q-Qʹ by means of the rotation of the cursor and, in the same way the two segments 13 and 14 of track C are connected with track D, sequentially, through brushes R and Rʹ.

The multiple sources of direct current, three in the practical sample design shown in the figure, and marked L, M, and N, are interconnected in series and the whole is connected to the tracks as shown in the diagram in the figure.

Cursor P is in turn connected to a DC motor which causes it to rotate and, likewise, the brushes, at a speed which is required according to the frequency of the alternating current to be obtained.

During each complete turn of the cursor, in other words, every 360º, an alternating current appears at the output terminals I-J at an amplitude which is in accordance with the number of DC current supplies and their voltages, and with a frequency which is a function of the speed of the motor. When the motor turns over at 3000 r/min, the frequency will be 50 cps.

The voltage of this alternating current may be raised if wished, by fitting a transformer, 25, in link with the I-J AC output, and with the suitable characteristics.

Specifically, the transformation process of the direct current into alternating current is produced as follows:
- When cursor P is between segments 1 and 12 of track A, brush Qʹ is isolated from that track so that the track, for its part, is cut off from B, at the same time as brush R is located between segments 13 and 14 of track C so that it is cut off from track D; Therefore, with tracks B and D isolated, there will be no voltage in the I-J output terminals.
- From this point on, in the rotation of the cursor, 23, brush Qʹ comes into contact with segment 1 of track A, which is at the positive potential of the battery L, i.e. at point F potential, in relation with point E, which in turn corresponds to the battery's negative potential, so that the positive potential F is supplied to the output terminal I through brush Q-Qʹ, and negative potential E is transmitted to the output terminal J through brushes R-Rʹ as these are opposed to the Q-Qʹ brushes within the cursor P.
- As cursor P continues in its advance, brush Qʹ will come into contact with segment 2 of track A before losing segment 1, so that output I receives an increase of positive potential in respect of J, corresponding to the sum of battery L plus battery M and defined by point G.
- During the instant at which brush Sʹ is in contact simultaneously on segments 1-2 of track A, battery M is in short-circuit and the related discharge current is created. In order to prevent this problem of the discharge current, there is provision for the arrangement of the blocking diodes 15, 16, 17, 18, 19, 20, 21, 22, 23, and 24, as shown in the diagram.
- Still following the movement of the cursor, brush Qʹ comes into contact in the same way with segments 3 and 4 of track A and terminal I will receive maximum voltage as againts terminal J, in correspondence with connection H and according to the number of batteries, as pointed out above.
- From segment 4 onwards, and during the cursor's movement as far as segment 6 (given that the respective connections with the supply sources F-G-H which previously moved in a rising potential direction, do it in a descending potential direction) the real potential at point I will drop as it rise during the movement along sectors 1, 2 and 3, until reaching zero, specifically at the point where brush Qʹ is located between segments 6 and 7.
during the 180ª rotation described, a positive hemicycle or half wave has been produced in terminals I-J.

At the moment in which brush Q comes into contact with segment 7 of track A, brush R also comes into contact with segment 14 of track C, so that a change of polarity is given and, with it, a change in the direction of the current at terminals I-J.
- During the movement of the cursor from the beginning of segment 7 to the end of segment 12, in other words, during the remaining 180º of the complete cycle, the same phenomenon is created as in the first hemicycle, but now with the current in the opposite direction, i.e. so as to obtain the relative wave hemicycle.
- When the cursor once more moves to segment 1 of part A, brush R once more passes to segment 14 of track C and a new operative cycle of the system is initiated.

In accordance with the following, at the output terminals I-J and in the secondary of the transformer 25, an alternating current is obtained with a voltage which is a function of the characteristics of the DC supplies L, M, and N, with its own number and with a frequency which, for its part, will be a function of the speed with which cursor P is rotating.

As has also been pointed out above, by connecting the DC sources L, M and N so that the voltage at each link point F, G, H, is a function of the maximum amplitude of the AC voltage to be obtained, and playing with the angle or conduction time of each link point, it is possible to secure any type of wave with the general scope of alternating current whether, sinusoidal, trapezoid, square, etc.

By synchronizing the sweep of cursor P with that of another similar generator, it is possible to couple the two generators in parallel.

On the other hand, by establishing simultaneous sweeps, in other words, by making use of severals cursors which are angled out of phase by a pre-determined amount, it is possible to obtain poly-phased alternating current.
it should be highlighted, as has also been pointed out above, that with the establishment at the points of reversal of the current of uni-directional barriers or static switches, it is possible to recover the energy which is generated as a result of Lenz's law, with inductive charges, so as to secure energy utilization; This energy may be applied to the charge itself, or else fed to storage sources.

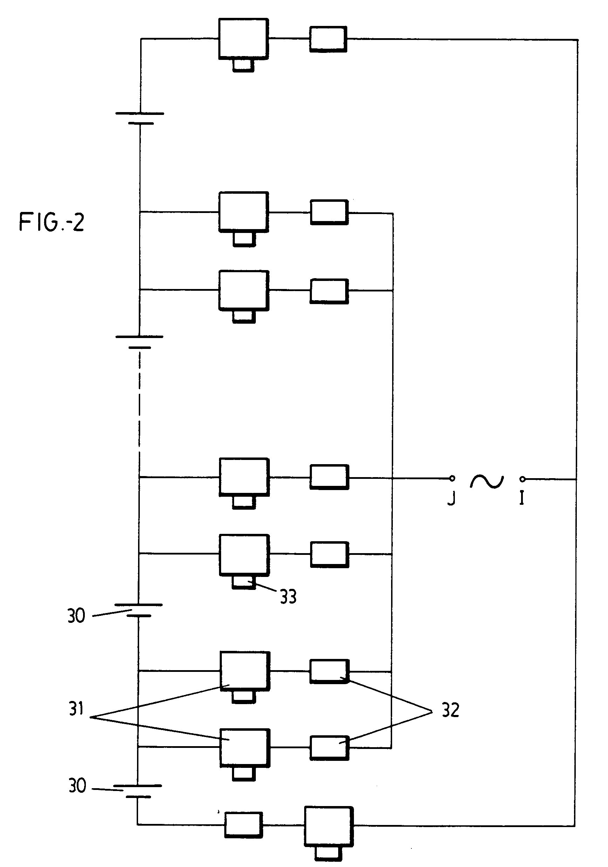

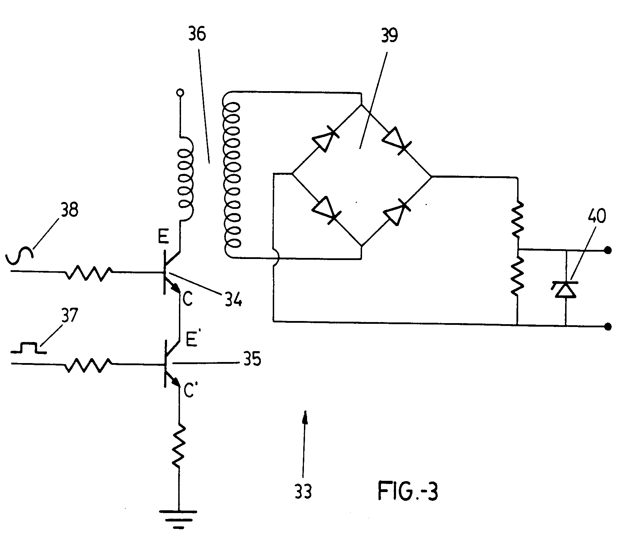

As has been mentioned, the representation of figure 1, described exhaustively, has no further aim than to give a clear understanding of the procedure for the conversion of electrical energy as advanced here. For the practical design of this procedure, a circuit is used as shown in figure 2, in which there are no moving parts, and in which the supply sources are marked number 30, and where the tracks and brushes have been replaced by static switches, 31, with their corresponding uni-directional barriers, 32, and in which the same references, I-J, are preserved for the corresponding charge terminals or AC output terminals. Special mention ought to be made of the control circuits, 33, for the regulation of the static switches, 31, which are shown in detail in figure 3.

With this circuit, in figure 3, and, as has already been pointed out, it is possible to create control impulses for the static switches, 31, with floating earth or ground, in other words so that the said control impulses are insulated from any other circuit, in the general context of the convertor.

Two transistors, 34 and 35, are used to do this; they are connected so that transistor 34's transmitter is connected to transistor 35's collector so that the former is able to condict only as long as the latter does so.

The collector of transistor 34 is connected to the supply, i.e. to the corresponding static switch, through the primary of a transformer, 36, with a suitable transformation ratio, and with a core in accordance with the frequency of the signal applied to it.

At the base of transistor 35, a series of impulses, 37, are applied, in secuential form, so as to define the conduction of the linking points, the oft-cited "sequential sweep".
Both transistors will conduct during the period of the sequential impulse, 37, applied to the base of transistor 35 and, as a consequence, in the secondary of transformer 36 signal 38 will appear, applied to the base of transistor 34, with an amplified voltage in function of the transformation ratio.

This signal is rectified with a full-wave rectifier, 39, on the diode bridge which is shown in figure 3, so as to obtain an impulse equal to the one applied to the base of transistor 35, with an amplified voltage, and insulated from earth or ground, in other words, with a floating earth or ground, which will serve to control the conduction of the static switches at the linking points.

As has also been pointed out above, in order to perfect the impulse and cut the peak ripple, a resistive divider is used with a Zener diode, 40, which makes it possible to cut the impulse at the desired level so as to establish the up and down times likewise as required.

It is not thought necessary to amplify this description for any expert in the field to understand the scope of the invention and the advantages derived from it.

## Claims

1. A method for converting electrical energy from DC form to AC form, comprising the steps of
providing a plurality of DC sources (L) each having two source terminals (E,F,G,H) of opposite polarity;
connecting said DC sources (L) in series to form a resulting string of DC sources (L) provided with intermediate terminals (F,G) each corresponding to two source terminals of a respective one of two distinct DC sources (L) and two end terminals (E,H) each corresponding to one source terminal of a respective one of two distinct DC sources (L), said source terminals in each case being of opposite polarity;
connecting said intermediate and end terminals (E,F,G,H) pairwise in succession to a pair of output terminals (I,J) for constructing a wave form of the AC energy from a succession of instant DC voltage differences between said pairwise connected terminals; and
providing current rectifier means (32) allowing only mono-directional current flow between said source terminals (E,F,G,H) and the respective output terminals (I,J);
**characterized in that**
an end terminal (E) corresponding to a negative source terminal of a DC source (L) is connected to one output terminal (J) and an intermediate terminal (F) corresponding to a positive source terminal of the same DC source (L) is connected to the other output terminal (I);
thereafter, the other intermediate and end terminals (G,H) are connected in succession to said other output terminal (I) to generate a first quarter-cycle of said wave form in which an amplitude of said wave form is positive and increasing;
thereafter, said other intermediate and end terminals (G,H) are connected in reverse succession to said other output terminal (I) to generate a second quarter-cycle of said wave form in which an amplitude of said wave form is positive and decreasing;
thereafter, said end terminal (E) and said intermediate and end terminals (F,G,H) are disconnected from the respective output terminals (I,J), which provides for a zero-energy time period during which said output terminals (I,J) both are disconnected from any source terminal (E,F,G,H);
thereafter, an end terminal (H) corresponding to a positive source terminal of a DC source (L) is connected to said one output terminal (J) and an intermediate terminal (G) corresponding to a negative source terminal of the same DC source (L) is connected to said other output terminal (I);
thereafter, the other intermediate and end terminals (F,E) are connected in succession to said other output terminal (I) to generate a third quarter-cycle of said wave form in which an amplitude of said wave form is negative and decreasing;
thereafter, said other intermediate and end terminals (F,E) are connected in reverse succession to said other output terminal (I) to generate a fourth quarter-cycle of said wave form in which an amplitude of said wave form is negative and increasing;
thereafter, said end terminal (H) and said intermediate and end terminals (E,F,G) are disconnected from the respective output terminals (I,J), which provides for a zero-energy time period during which said output terminals (I,J) both are disconnected from any source terminal (E,F,G,H);
and thereafter, the above sequence of steps is repeated at recurrent times to generate successive cycles of said wave form.

2. The method of claim 1, **characterized in that** the process of performing and repeating the sequence of steps of claim 1 is performed at a variable speed selected so as to allow to construct a wave form of the AC energy having a desired frequency.

3. The method of claim 1, **characterized in that** the DC sources (L) each are provided with a respective predetermined voltage between their respective source terminals connected in series in a predetermined arrangement, and said voltages and arrangement are combined so as to allow to generate successive cycles of a predetermined e.g. sine, trapezoid, square or other wave form of predetermined amplitude.

4. The method of claim 3, **characterized in that** there is provided a respective predetermined duration of each step of the sequence of steps of claim 1, and said voltages, arrangement and durations are combined so as to allow to generate successive cycles of a predetermined e.g. sine, trapezoid, square or other wave form of predetermined amplitude.

5. The method of any of claims 1 to 4, **characterized in that** the process of performing and repeating the sequence of steps of claim 1 is performed using one string of DC sources (L) and a plurality of pairs of output terminals (I,J), the sequence of steps of claim 1 being performed at one and the same speed but displaced in time in respect of each pair of output terminals (I,J) so as to generate at each pair of output terminals (I,J) successive cycles of said wave form while generating a phase difference between wave forms at different pairs of output terminals (I,J).

6. The method of any of claims 1 to 4, **characterized in that** the process of performing and repeating the sequence of steps of claim 1 is performed using a plurality of strings of DC sources (L) and a corresponding plurality of pairs of output terminals (I,J), the sequence of steps of claim 1 being performed at one and the same speed but displaced in time in respect of each of said strings of DC sources (L) and corresponding pairs of output terminals (I,J) so as to generate at each pair of output terminals (I,J) successive cycles of said wave form while generating a phase difference between wave forms at different pairs of output terminals (I,J).

7. The method of claim 1, **characterized in that** an inductive load is connected across the output terminals (I,J) and any energy produced during reversals in polarity at the output terminals (I,J) is recovered from a current induced in said inductive load as a consequence of Lenz's law.

8. The method of claim 1, **characterized in that** the connections are established by means of static switches, each of which is controlled by means of pulses referenced to a floating ground.

9. A device for converting electrical energy from DC form to AC form according to the method of claim 1, said device being comprised of
a plurality of DC sources (L) each having two source terminals (E,F,G,H) of opposite polarity, said DC sources (L) being connected in series as a string of DC sources (L) provided with intermediate terminals (F,G) each corresponding to two source terminals of a respective one of two distinct DC sources (L) and two end terminals (E,H) each corresponding to one source terminal of a respective one of two distinct DC sources (L), said source terminals in each case being of opposite polarity;
a pair of output terminals (I,J) of the device;
static switch means (31) for connecting said intermediate and end terminals (E,F,G,H) pairwise in succession to said pair of output terminals (I,J); and
current rectifier means (32) allowing only mono-directional current flow between said source terminals (E,F,G,H) and the respective output terminals (I,J);
**characterized in that**
the static switch means (31) are adapted for selectively establishing and disconnecting a connection of a selected one of the end terminals (E,H) to one output terminal (J) and of the other intermediate and end terminals (F,G,H;E,F,G) to the other output terminal (I).

10. The device of claim 9, **characterized in that** the static switch means (31) are controlled by control circuit means (33) insulated from ground and having a floating output voltage with respect to ground.

11. The device of claim 10, **characterized in that** the control circuit means (33) each are comprised of two transistors (34,35) connected in series with each other and with a primary winding of a transformer (36) whose secondary winding is connected to the respective static switch (31) by means of a full-wave rectifier (39), one of said transistors (35) being driven by a pulsed control signal (37) and the other transistor (34) being driven by a sine signal (38), the transformer (36) being adapted to raise the voltage of said sine signal (38) at the frequency thereof.

12. The device of claim 11, **characterized in that** the connection of the full-wave rectifier (39) to the static switch (31) is provided with a Zener diode voltage clipping means (40).

## Patentansprüche

1. Verfahren für die Umwandlung elektrischer Energie von Gleichstrom zu Wechselstrom, die folgenden Schritte umfassend:
- Bereitstellen einer Vielzahl von Gleichstromquellen (L), wobei jede zwei Quellenanschlüsse (E,F,G,H) von entgegengesetzter Polarität hat;
- Verbinden der genannten Gleichstromquellen (L) in Reihe, um eine resultierende Folge von Gleichstromquellen (L), zu bilden, versehen mit zwischenanschlüssen (F,G), wobei jeder zwei Quellenanschlüssen einer entsprechenden von zwei gesonderten Gleichstromquellen (L) entspricht, und zwei Endanschlüssen (E,H), wobei jeder einem Quellenanschluß eines entsprechenden von zwei gesonderten Gleichstromquellen (L) entspricht, wobei die genannten Quellenanschlüsse in jedem Fall von entgegengesetzter Polarität sind;
- Verbinden der Zwischen- und Endanschlüsse (E,F,G,H) paarweise aufeinanderfolgend mit einem Paar von Ausgangsanschlüssen (I,J) zum Aufbau einer Wellenform der Wechselstromenergie aus einer Folge von momentanen Gleichspannungsdifferenzen zwischen den genannten paarweise verbundenen Anschlüssen; und
- Bereitstellen von Stromwandlermitteln (32), welche lediglich Stromfluß in einer Richtung zwischen den genannten Quellenanschlüssen (E,F,G,H) und den entsprechenden Ausgangsanschlüssen (I,J) zulassen; dadurch gekennzeichnet, daß
- ein Endanschluß (E), welcher einem negativen Quellenanschluß einer Gleichstromquelle (L) entspricht, verbunden ist mit einem Ausgangsanschluß (J) und ein Zwischenanschluß (F), welcher einem positiven Quellenanschluß derselben Gleichstromquelle (L) entspricht, verbunden ist mit dem anderen Ausgangsanschluß (I);
- danach die anderen Zwischen- und Endanschlüsse (G,H) aufeinanderfolgend angeschlossen werden an den anderen Ausgangsanschluß (I), um einen ersten Viertelzyklus der genannten Wellenform, in welcher eine Amplitude der genannten Wellenform positiv und steigend ist, zu erzeugen;
- danach die genannten anderen Zwischen- und Endanschlüsse (G,H) in umgekehrter Reihenfolge verbunden werden mit dem genannten Ausgangsanschluß (I), um einen zweiten Viertelzyklus der Wellenform, in welcher eine Amplitude der genannten Wellenform positiv und fallend ist, zu erzeugen;
- danach der genannte Endanschluß (E) und die genannten Zwischen- und Endanschlüsse (F,G,H) getrennt werden von den entsprechenden Ausgangsanschlüssen (I,J), was zu einem Nullenergie-Zeitraum führt, während welchem die genannten Ausgangsanschlüsse (I,J) beide getrennt sind von jedem Quellenanschluß (E,F,G,H);
- danach ein Endanschluß (H), welcher einem positiven Quellenanschluß einer Gleichstromquelle (L) entspricht, angeschlossen wird an den genannten einen Ausgangsanschluß (J) und ein Zwischenanschluß (G), welcher einem negativen Quellenanschluß derselben Gleichstromquelle (L) entspricht, angeschlossen wird an den genannten anderen Ausgangsanschluß (I);
- danach die anderen Zwischen- und Endanschlüsse (F,E) aufeinanderfolgend angeschlossen werden an den genannten anderen Ausgangsanschluß (I), um einen dritten Viertelzyklus der genannten Wellenform, in welcher eine Amplitude der genannten Wellenform negativ und fallend ist, zu erzeugen;
- danach die genannten anderen Zwischen- und Endanschlüsse (F,E) in umgekehrter Reihenfolge angeschlossen werden an den genannten anderen Ausgangsanschluß (I), um einen vierten Viertelzyklus der genannten Wellenform, in welcher eine Amplitude der genannten Wellenform negativ und steigend ist, zu erzeugen;
- danach der genannte Endanschluß (H) und die genannten Zwischen- und Endanschlüsse (E,F,G) getrennt werden von den entsprechenden Ausgangsanschlüssen (I,J), was zu einem Zeitraum der Nullenergie führt, während welchem die genannten Ausgangsanschlüsse (I,J) beide von jedem Quellenanschluß (E,F,G,H) getrennt sind;
- und danach die oben erwähnte Folge von Schritten wiederholt wird zu wiederkehrenden Zeiten, um aufeinanderfolgende Zyklen der genannten Wellenform zu erzeugen.

2. Verfahren nach Anspruch 1, dadurch gekennzeichnet, daß der Vorgang des Durchführens und Wiederholens der Folge von Schritten nach Anspruch 1 durchgeführt wird mit einer veränderlichen Geschwindigkeit, welche so gewählt wird, daß eine Wellenform der Wechselstromenergie, welche eine gewünschte Frequenz aufweist, aufgebaut werden kann.

3. Verfahren nach Anspruch 1, dadurch gekennzeichnet, daß die Gleichstromquellen (L) jeweils versehen sind mit einer entsprechenden vorbestimmten Spannung zwischen deren entsprechenden Quellenanschlüssen, welche in einer vorbestimmten Anordnung in Reihe geschaltet sind, und die genannten Spannungen und die genannte Anordnung so kombiniert werden, daß aufeinanderfolgende Zyklen einer vorbestimmten beispielsweise Sinus-, Trapez-, Rechteck- oder anderer Wellenform vorbestimmter Amplitude erzeugt werden können.

4. Verfahren nach Anspruch 3, dadurch gekennzeichnet, daß eine entsprechende vorbestimmte Zeitdauer jedes Schrittes der Folge von Schritten nach Anspruch 1 vorgesehen ist und die genannten Spannungen, die genannte Anordnung und die genannten Zeiten so kombiniert sind, daß aufeinanderfolgende Zyklen einer vorbestimmten beispielsweise Sinus-, Trapez-, Rechteck- oder anderer Wellenform vorbestimmter Amplitude erzeugt werden können.

5. Verfahren nach einem der Ansprüche 1 bis 4, dadurch gekennzeichnet, daß der Vorgang des Durchführens und Wiederholens der Folge von Schritten nach Anspruch 1 durchgeführt wird unter Verwendung einer Reihe von Gleichstromquellen (L) und einer Anzahl von Paaren von Ausgangsanschlüssen (I,J), wobei die Folge von Schritten nach Anspruch 1 durchgeführt wird mit ein und derselben Geschwindigkeit, jedoch zeitlich versetzt in bezug auf jedes Paar von Ausgangsanschlüssen (I,J), um an jedem Paar von Ausgangsanschlüssen (I,J) aufeinanderfolgende Zyklen der genannten Wellenform zu erzeugen, während eine Phasendifferenz zwischen Wellenformen an verschiedenen Paaren von Ausgangsanschlüssen (I,J) erzeugt wird.

6. Verfahren nach einem der Ansprüche 1 bis 4, dadurch gekennzeichnet, daß der Vorgang des Durchführens und Wiederholens der Folge von Schritten nach Anspruch 1 durchgeführt wird unter Verwendung einer Anzahl von Reihen von Gleichstromquellen (L) und einer entsprechenden Anzahl von Paaren von Ausgangsanschlüssen (I,J), wobei die Folge von Schritten nach Anspruch 1 durchgeführt wird mit ein und derselben Geschwindigkeit, jedoch zeitlich versetzt in bezug auf jede der genannten Reihen von Gleichstromquellen (L) und entsprechenden Paaren von Ausgangsanschlüssen (I,J), um an jedem Paar von Ausgangsanschlüssen (I,J) aufeinanderfolgende Zyklen der genannten Wellenform zu erzeugen, während eine Phasendifferenz zwischen den Wellenformen an verschiedenen Paaren von Ausgangsanschlüssen (I,J) erzeugt wird.

7. Verfahren nach Anspruch 1, dadurch gekennzeichnet, daß eine induktive Last angeschlossen wird über die Ausgangsanschlüsse (I,J) und jede Energie, welche während der Umkehr der Polarität an den Ausgangsanschlüssen (I,J) erzeugt wird, wiedergewonnen wird aus einem Strom, welcher in der genannten induktiven Last induziert wird als eine Folge des Lenzschen Gesetzes.

8. Verfahren nach Anspruch 1, dadurch gekennzeichnet, daß die Verbindungen hergestellt werden mittels statischer Schalter, von welchen jeder gesteuert wird mittels Impulsen mit nichtgeerdetem Referenzpunkt.

9. Vorrichtung für die Umwandlung elektrischer Energie von Gleichstrom zu Wechselstrom nach dem Verfahren nach Anspruch 1, wobei die genannte Vorrichtung besteht aus
- einer Anzahl von Gleichstromquellen (L), wobei jede zwei Quellenanschlüsse (E,F,G,H) entgegengesetzter Polarität hat, wobei die genannten Gleichstromquellen (L) in Reihe miteinander verbunden sind als eine Reihe von Gleichstromquellen (L), versehen mit Zwischenanschlüssen (F,G), von welchen jeder zwei Quellenanschlüssen einer entsprechenden von zwei gesonderten Gleichstromquellen (L) entspricht, und zwei Endanschlüssen (E,H), von welchen jeder einem Quellenanschluß einer entsprechenden von zwei gesonderten Gleichstromquellen (L) entspricht, wobei die Quellenanschlüsse in jedem Fall von entgegengesetzter Polarität sind;
- einem Paar von Ausgangsanschlüssen (I,J) der Vorrichtung;
- statischen Schaltermitteln (31) zum Verbinden der genannten Zwischen- und Endanschlüsse (E,F,G,H) paarweise aufeinanderfolgend mit dem genannten Paar von Ausgangsanschlüssen (I,J); und
- Stromgleichrichtermitteln (32), welche Stromfluß nur zulassen in einer Richtung zwischen den genannten Quellenanschlüssen (E,F,G,H) und den entsprechenden Ausgangsanschlüssen (I,J); dadurch gekennzeichnet, daß
die statischen Schaltermittel (31) geeignet sind für selektives Herstellen und Trennen einer Verbindung eines gewählten Anschlusses der Endanschlüsse (E,H) zu einem Ausgangsanschluß (J) und der anderen Zwischen- und Endanschlüsse (F,G,H;E,F,G) zu dem anderen Ausgangsanschluß (I).

10. Vorrichtung nach Anspruch 9, dadurch gekennzeichnet, daß die statischen Schaltermittel (31) gesteuert werden mittels Steuerschaltungsmitteln (33), welche isoliert sind gegen Erde und eine schwebende Ausgangsspannung gegenüber Erde haben.

11. Vorrichtung nach Anspruch 10, dadurch gekennzeichnet, daß die Steuerschaltungsmittel (33) jeweils bestehen aus zwei Transistoren (34, 35), verbunden in Reihe miteinander und mit einer Primärwicklung eines Transformators (36), dessen Sekundärwicklung verbunden ist mit dem entsprechenden statischen Schalter (31) mittels eines Zweiweggleichrichters (39), wobei einer der genannten Transistoren (35) getrieben wird von einem pulsierenden Steuersignal (37) und der andere Transistor (34) getrieben wird von einem Sinussignal (38), wobei der Transformator (36) geeignet ist, die Spannung des genannten Sinussignals (38) bei dessen Frequenz zu erhöhen.

12. Vorrichtung nach Anspruch 11, dadurch gekennzeichnet, daß die Verbindung des Zweiweggleichrichters (39) mit dem statischen Schalter (31) versehen ist mit einem Zenerdiodenspannungsbegrenzungsmittel (40).

## Revendications

1. Procédé pour convertir de l'énergie électrique de la forme courant continu à la forme courant alternatif, comprenant les étapes consistant à :
procurer plusieurs sources de courant continu (L), chacune possédant deux bornes de source (E, F, G, H) de polarité opposée;
relier lesdites sources de courant continu (L) en série pour former une chaîne résultante de sources (L) de courant continu munies de bornes intermédiaires (F, G), chacune correspondant à deux bornes de source de l'une de deux sources distinctes de courant continu (L), respectivement, ainsi que deux bornes terminales (E, H) correspondant chacune à une borne de source de l'une de deux sources distinctes de courant continu (L), respectivement, lesdites bornes de source étant de polarité opposée dans chaque cas;
relier lesdites bornes intermédiaires et terminales (E, F, G, H) par paires successives à une paire de bornes de sortie (I, J) pour construire une forme d'onde de l'énergie à courant alternatif à partir d'une succession de différences de tension instantanées à courant continu entre lesdites bornes reliées par paires; et
procurer un moyen redresseur de courant (32) permettant uniquement une circulation de courant unidirectionnelle entre lesdites bornes de source (E, F, G, H) et les bornes de sortie respectives (I, J);
caractérisé en ce que
une borne terminale (E) correspondant à une borne de source négative d'une source de courant continu (L) est reliée à une borne de sortie (J), et une borne intermédiaire (F) correspondant à une borne de source positive de la même source de courant continu (L) est reliée à l'autre borne de sortie (I);
ensuite, les autres bornes intermédiaire et terminale (G, H) sont reliées en séquence à ladite autre borne de sortie (I) pour générer un premier quartier de ladite forme d'onde, dans lequel une amplitude de ladite forme d'onde est positive et croissante;
ensuite, lesdites autres bornes intermédiaire et terminale (G, H) sont reliées en séquence inverse à ladite autre borne de sortie (I) pour générer un second quartier de ladite forme d'onde, dans lequel une amplitude de ladite forme d'onde est positive et décroissante;
ensuite, ladite borne terminale (E) et lesdites bornes intermédiaire et terminale (F, G, H) sont déconnectées des bornes de sortie respectives (I, J), ce qui procure un laps de temps à énergie zéro au cours duquel lesdites bornes de sortie (I, J) sont toutes deux déconnectées de n'importe quelle borne de source (R, F, G, H);
ensuite, une borne terminale (H) correspondant à une borne de source positive d'une source à courant continu (L) est reliée à ladite première borne de sortie (J), et une borne intermédiaire (G) correspondant à une borne de source négative de la même source à courant continu (L) est reliée à ladite autre borne de sortie (I);
ensuite, les autres bornes intermédiaire et terminale (F, E) sont reliées en séquence à ladite autre borne de sortie (I) pour générer un troisième quartier de ladite forme d'onde, dans lequel une amplitude de ladite forme d'onde est négative et décroissante;
ensuite, lesdites autres bornes intermédiaire et terminale (F, E) sont reliées en séquence inverse à ladite autre borne de sortie (I) pour générer un quatrième quartier de ladite forme d'onde, dans lequel une amplitude de ladite forme d'onde est négative et décroissante;
ensuite, ladite borne terminale (H) et lesdites bornes intermédiaires et terminale (E, F, G) sont déconnectées des bornes de sortie respectives (I, J), ce qui procure un laps de temps à énergie zéro au cours duquel lesdites bornes de sortie (I, J) sont toutes deux déconnectées de n'importe quelle borne de source (E, F, G, H);
et ensuite, on répète la séquence d'étapes ci-dessus à des moments périodiques pour générer des cycles successifs de ladite forme d'onde.

2. Procédé selon la revendication 1, caractérisé en ce qu'on met en oeuvre le processus consistant à réaliser et à répéter la séquence des étapes de la revendication 1, à vitesse variable sélectionnée afin de permettre de construire une forme d'onde de l'énergie à courant alternatif ayant une fréquence désirée.

3. Procédé selon la revendication 1, caractérisé en ce que les sources à courant continu (L) sont chacune munies d'une tension prédéterminée respective entre leurs bornes de source respectives reliées en série en un arrangement prédéterminé, et lesdites tensions et ledit arrangement étant combinés de façon à permettre la génération de cycles successifs d'une forme d'onde prédéterminée, par exemple sinusoïdale, trapézoïdale, carrée ou analogues d'amplitude prédéterminée.

4. Procédé selon la revendication 3, caractérisé en ce qu'on procure une durée prédéterminée, respective pour chaque étape de la séquence d'étapes de la revendication 1 et on combine lesdites tensions, ledit arrangement et lesdites durées de façon à permettre la génération de cycles successifs d'une forme d'onde prédéterminée, par exemple sinusoidale, trapézoïdale, carrée ou analogues d'amplitude prédéterminée.

5. Procédé selon l'une quelconque des revendications 1 à 4, caractérisé en ce qu'on met en oeuvre le processus de réalisation et de répétition de la séquence des étapes de la revendication 1 en utilisant une chaîne de sources de courant continu (L) et plusieurs paires de bornes de sortie (I, J), la séquence d'étapes de la revendication 1 étant mise en oeuvre à une seule et même vitesse, mais décalée dans le temps par rapport à chaque paire de bornes de sortie (I, J) de façon à générer, à chaque paire de bornes de sortie (I, J), des cycles successifs de ladite forme d'onde, tout en générant une différence de phase entre les formes d'onde à différentes paires de bornes de sortie (I, J).

6. Procédé selon l'une quelconque des revendications 1 à 4, caractérisé en ce qu'on met en oeuvre le processus de réalisation et de répétition de la séquence des étapes de la revendication 1 en utilisant plusieurs chaînes de sources de courant continu (L) et plusieurs paires correspondantes de bornes de sortie (I, J), la séquence des étapes de la revendication 1 étant mise en oeuvre à une seule et même vitesse, mais décalée dans le temps par rapport à chacune desdites chaînes de sources de courant continu (L) et des paires correspondantes de bornes de sortie (I, J) de façon à générer, à chaque paire de bornes de sortie (I, J), des cycles successifs de ladite forme d'onde, tout en générant une différence de phase entre les formes d'onde à différentes paires de bornes de sortie (I, J).

7. Procédé selon la revendication 1, caractérisé en ce qu'une charge inductive est reliée à travers les bornes de sortie (I, J) et n'importe quelle énergie produite au cours des inversions de polarité aux bornes de sortie (I, J) est récupérée à partir d'un courant induit dans ladite charge inductive comme conséquence de la loi de Lenz.

8. Procédé selon la revendication 1, caractérisé en ce que les liaisons sont établies au moyen de commutateurs statiques dont chacun est commandé au moyen d'impulsions isolées de la terre.

9. Dispositif pour convertir de l'énergie électrique de la forme courant continu à la forme courant alternatif conformément au procédé de la revendication 1, ledit dispositif comprenant
plusieurs sources de courant continu (L) possédant chacune deux bornes de source (E, F, G, H) de polarité opposée, lesdites sources de courant continu (L) étant reliées en série sous forme d'une chaîne de sources de courant continu (L) comprenant des bornes intermédiaires (F, G) correspondant chacune à deux bornes de source de l'une de deux sources distinctes de courant continu (L), respectivement, et deux bornes terminales (E, H) correspondant chacune à une borne de source de l'une de deux sources distinctes de courant continu (L), respectivement, lesdites bornes de source étant, dans chaque cas, de polarité opposée;
une paire de bornes de sortie (I, J) du dispositif;
des moyens de commutateurs statiques (31) pour relier lesdites bornes intermédiaires et terminales (E, F, G, H) par paires successives à ladite paire de bornes de sortie (I, J); et
un moyen de redresseur de courant (32) permettant uniquement une circulation de courant unidirectionnelle entre lesdites bornes de source (E, F, G, H) et les bornes de sortie respectives (I, J);
caractérisé en ce que
les moyens de commutateurs statiques (31) sont conçus pour établir et couper sélectivement une liaison entre une des bornes terminales sélectionnées (E, H) et une borne de sortie (J) et entre les autres bornes intermédiaires et terminales (F, G, H; E, F, G) et l'autre borne de sortie (I).

10. Dispositif selon la revendication 9, caractérisé en ce que les moyens de commutateurs statiques (31) sont commandés par des moyens de circuits de commande (33) isolés du sol et possédant une tension de sortie isolée par rapport au sol.

11. Dispositif selon la revendication 10, caractérisé en ce que des moyens de circuits de commande (33) comprennent chacun deux transistors (34, 35) reliés en série l'un à l'autre et à un enroulement primaire d'un transformateur (36) dont l'enroulement secondaire est relié au commutateur statique respectif (31) au moyen d'un redresseur pleine onde (39), un desdits transistors (35) étant entraîné par un signal de commande à pulsions (37) et l'autre transistor (34) étant entraîné par un signal sinusoïdal (38), le transformateur (36) étant conçu pour élever la tension dudit signal sinusoïdal (38) à la fréquence de ce dernier.

12. Dispositif selon la revendication 11, caractérisé en ce que la liaison entre le redresseur pleine onde (39) et le commutateur statique (31) est équipée d'un moyen d'écrêtage de tension (40) à diode Zener.
